# DEMANDE DE BREVET EUROPEEN

(11) **EP 3 098 501 A1**
(43) Date de publication de la demande: **30.11.2016**
(21) Numéro de dépôt: 16171566.9
(22) Date de dépôt: 26.05.2016
(51) Int. Cl.: F21S 8/10, B32B 17/06, H01L 27/32, H01L 51/52

(54) **DISPOSITIF D'ÉCLAIRAGE POUR VÉHICULE AUTOMOBILE**

(30) Priorité: 26.05.2015 FR 1554694
(71) Demandeur: VALEO VISION, 93012 Bobigny Cedex (FR)
(72) Inventeur: HUE, David, 95430 BUTRY SUR OISE (FR); SAGNA, Boubacar, 78500 SARTROUVILLE (FR)

(57) **Abrégé**

L'invention a pour objet un dispositif d'éclairage ou de signalisation pour véhicule automobile, qui comprend au moins une diode électroluminescente organique (S') et au moins une diode électroluminescente (4). Dans le dispositif selon l'invention, des couches conductrices (1A, 1 B, 1C) d'alimentation électrique de ladite au moins une diode électroluminescente (4) et de ladite au moins une diode électroluminescente organique (S') sont interposées entre au moins un premier et un deuxième substrats (2a, 2b), translucides.

## Description

Le domaine de la présente invention est celui des dispositifs d'éclairage ou de signalisation pour véhicules automobiles, et la présente invention se rapporte plus particulièrement aux dispositifs d'éclairage ou de signalisation qui mettent en oeuvre au moins une diode électroluminescente.

Dans le domaine automobile, les évolutions esthétiques, règlementaires, et l'évolution des contraintes de poids et d'encombrement des éléments entrant dans le véhicule font qu'il est de plus en plus recherché de réaliser des dispositifs d'éclairage ou de signalisation qui combinent possibilités esthétiques étendues avec puissance lumineuse, durée de vie élevée, faible encombrement, souplesse et facilité de mise en oeuvre. Une voie de recherche dans cette direction est la mise en oeuvre d'éclairages surfaciques. Toutefois, les contraintes liées aux différentes fonctions d'éclairage ou de signalisation d'un véhicule sont multiples et parfois contradictoires. Ainsi, par exemple, pour la signalisation d'un freinage (fonction "stop"), une puissance lumineuse forte est définie règlementairement et sera recherchée. En revanche, pour la signalisation simple du véhicule lorsque celui-ci circule, par exemple, en ville dans un environnement par ailleurs lumineux (fonction assurée actuellement par les lampes de ville ou lanternes du véhicule), une puissance lumineuse forte n'est pas nécessaire, et on recherchera plutôt un éclairage de puissance moyenne étendu en surface pour une meilleure visibilité par les autres usagers de la route.

On connaît les avantages offerts par l'utilisation de diodes électroluminescentes, également appelées LED dans ce qui suit, dans le domaine de l'éclairage ou de la signalisation pour véhicules automobiles : faible consommation au regard des sources lumineuses classiques telles que les lampes à halogène ou les lampes à xénon, taille réduite, bonne résistance mécanique, durée de vie élevée. Toutefois, une source lumineuse de type LED est de relativement petites dimensions et fournit un flux de lumière relativement localisé. Une LED se comporte ainsi sensiblement comme une source lumineuse ponctuelle avec, en outre, un fort contraste entre la zone qu'elle éclaire et la surface qui l'environne. L'éclairage à LED est donc peu compatible avec un éclairage surfacique.

Le document EP1437215 propose d'insérer une multiplicité de sources de type LED dans une feuille de vitrage. Ce document décrit un ensemble qui comporte une première feuille de verre sur laquelle est déposée une couche d'un matériau conducteur, et dans lequel des pistes conductrices sont délimitées dans cette couche de matériau conducteur. Des LED sont ensuite collées sur ces pistes conductrices, de telle manière que chaque LED soit en contact avec deux pistes conductrices différentes. Une couche de matériau thermoplastique et une deuxième couche de verre sont ensuite associées à l'ensemble constitué de la première couche de verre, des pistes conductrices et des LED, de telle manière que chaque LED se trouve enfermée dans la couche de matériau thermoplastique, entre la première et la deuxième couche de verre. Chaque LED se trouve ainsi encapsulée dans le panneau vitré. Différentes variantes peuvent être réalisées selon le même principe, en utilisant, par exemple, des feuilles de verre colorées, ou différents types de LED. Toutefois, un tel assemblage génère des problèmes thermiques, liés à la mise en oeuvre de plusieurs LED rapprochées. En outre, le mode d'éclairage même de chaque LED, c'est-à-dire sensiblement ponctuel, n'est pas compatible avec l'obtention d'un effet d'éclairage surfacique.

Le but de la présente invention est de proposer un dispositif d'éclairage pour véhicule automobile, qui permette d'obtenir un éclairage surfacique tout en présentant les avantages des dispositifs qui mettent en oeuvre des LED, en termes de puissance lumineuse en particulier. Pour ce faire, l'invention propose d'utiliser des sources lumineuses à diode électroluminescente organique, également appelées OLED dans ce qui suit, en combinaison avec des sources de type LED.

L'utilisation actuelle la plus courante des sources lumineuses de type OLED se situe dans le domaine des écrans plats et des afficheurs. La puissance lumineuse émise par une source de type OLED reste toutefois inférieure à celle émise par une source de type LED, et, pour une application au domaine de l'éclairage ou de la signalisation des véhicules automobiles, inférieure aux puissances requises règlementairement pour des fonctions telles que la fonction "stop" ou la fonction "clignotant", par exemple.

Pour atteindre son but, qui est d'obtenir à la fois un éclairage surfacique et une puissance lumineuse compatible avec les exigences règlementaires qui s'appliquent aux véhicules automobiles, l'invention a pour objet un dispositif pour l'éclairage et/ou la signalisation d'un véhicule automobile, qui comprend au moins une source lumineuse à diode électroluminescente (LED) et au moins une source lumineuse à diode électroluminescente organique (OLED), interposées entre au moins deux substrats translucides.

Plus précisément, l'invention propose de réaliser un dispositif d'éclairage et/ou de signalisation dans lequel l'ensemble émetteur de lumière comporte, placées entre deux substrats translucides, au moins deux électrodes entre lesquelles est inséré un ensemble de couches de matériaux organiques. Selon l'invention, des pistes d'alimentation électrique d'au moins une source de type LED sont agencées au sein d'une des électrodes, et au moins une source de type LED est rapportée à cheval sur deux, différentes, de ces pistes d'alimentation électrique, se trouvant ainsi encapsulée entre les deux substrats translucides. Selon l'invention également, les couches de matériaux organiques insérées entre les deux électrodes comprennent au moins une couche d'un matériau électroluminescent et un ensemble de couches de matériaux qui, sous l'effet d'une tension appliquée à leurs bornes, sont aptes à induire la luminescence dudit matériau électroluminescent. Insérées entre deux électrodes, ces couches organiques forment ainsi une diode électroluminescente organique, ou OLED. Avantageusement, les matériaux formant les différentes couches organiques sont des matériaux polymères dont la structure inclut des métaux de transition afin d'optimiser l'efficacité de la luminescence et, ainsi, d'améliorer l'efficacité et les performances de la source lumineuse à OLED ainsi formée.

Par sa conception même, une telle source OLED fournit un éclairage surfacique, la lumière étant émise par la totalité de la couche de matériau électroluminescent, ou couche émissive, là où une source de type LED n'émet de lumière qu'à partir de sa surface éclairante, qui est de petite taille. L'invention combine ainsi, au sein d'un même dispositif d'éclairage et/ou de signalisation, deux surfaces éclairantes distinctes qui se chevauchent : une première surface éclairante, associée à un éclairage de type LED, et une deuxième surface éclairante, associée à un éclairage de type OLED. Il devient donc possible, par exemple, d'utiliser l'éclairage de type OLED comme éclairage "de fond" auquel l'éclairage de type LED vient se superposer. L'invention permet alors, par exemple, tout en conservant la puissance lumineuse forte émise de l'éclairage de type LED, de réduire le fort contraste de luminosité entre la zone éclairée par la ou les sources LED et la zone environnant cette ou ces sources, améliorant ainsi le confort visuel des autres usagers de la route au regard du véhicule équipé d'un dispositif selon l'invention.

Selon un premier mode de réalisation, l'invention propose, d'une part, de réaliser un ensemble à LED dans lequel des pistes d'alimentation électrique des LED sont agencées dans une première couche conductrice insérée entre deux substrats translucides, et, d'autre part, d'utiliser cette première couche conductrice comme électrode pour au moins une source lumineuse de type OLED. Selon différentes variantes de ce mode de réalisation de l'invention, ladite première couche conductrice peut être utilisée comme anode ou comme cathode pour la ou les sources OLED. Quelle que soit la fonction d'électrode (anode ou cathode) donnée à la première couche conductrice de l'ensemble à LED, l'autre électrode à laquelle elle est associée pour former, avec les couches organiques placées entre elles, la ou les sources OLED du dispositif selon l'invention peut être, selon différentes variantes de réalisation, réalisée dans un matériau translucide ou présentant un aspect visuel différent, par exemple métallique, selon l'effet visuel recherché. Selon ces modes de réalisation, l'ensemble à LED et source de type OLED sont intimement imbriqués, et peuvent être simultanément éclairés lorsqu'une tension est appliquée entre leurs électrodes. Dans certaines configurations, lorsque l'ensemble à LED et source de type OLED sont alimentées par la même alimentation électrique, une résistance sera insérée en série avec la LED, par exemple dans le substrat ou dans le boitier de la LED, pour tenir compte du fait que la tension Vf pour une OLED est supérieure à celle d'une LED.

Selon d'autres modes de réalisation, une couche d'un matériau isolant et une couche conductrice supplémentaires, toutes deux translucides, sont insérées entre, d'une part, la première couche conductrice dans laquelle sont agencées les pistes conductrices d'alimentation électrique de l'ensemble à LED et, d'autre part, l'ensemble de couches organiques d'au moins une source de type OLED, de telle manière que OLED et LED soient superposées entre les deux substrats translucides, et qu'un éclairage différencié et indépendant de ces deux ensembles soit possible.

Lorsque l'invention est réalisée selon un tel mode de réalisation, elle permet de remplir, avec le même dispositif d'éclairage ou de signalisation, plusieurs fonctions d'éclairage ou de signalisation du véhicule. Il devient ainsi possible d'obtenir un éclairage surfacique de puissance moyenne pour la visibilité du véhicule par les autres usagers de la route, par exemple lorsque le véhicule se déplace au crépuscule dans une zone dans laquelle l'éclairage ambiant reste suffisant pour que le conducteur ait une bonne visibilité de la route, et d'obtenir, avec le même dispositif d'éclairage, une forte puissance lumineuse, par exemple lorsque le véhicule est amené à freiner (fonction "stop") ou à changer de file de circulation (fonction "clignotant"). Dans ce cas, le ratio de surface entre la première surface éclairante, fournie par l'éclairage de type LED, et la deuxième surface éclairante, fournie par l'éclairage de type OLED, sera avantageusement ajusté pour que les puissances lumineuses émises soient conformes aux exigences règlementaires pour les deux fonctions remplies par le dispositif selon l'invention.

Selon d'autres modes de réalisation encore, un dispositif optique complémentaire peut être associé à l'ensemble. Il peut s'agir, par exemple, d'une lentille, ou d'un guide de lumière utilisé pour guider ou pour focaliser la lumière émise par l'éclairage de type LED. Dans un tel cas, le dispositif optique peut être formé sur une surface extérieure d'un ou des substrats. Le dispositif optique est alors placé au moins en face d'au moins une des diodes électroluminescentes ponctuelles. Alternativement, un unique dispositif optique peut être installé au droit d'une pluralité de diodes électroluminescentes ponctuelles.

D'autres caractéristiques, détails et avantages de l'invention ressortiront plus clairement à la lecture de la description donnée ci-après à titre indicatif en relation avec des dessins dans lesquels :
- la figure 1 est une vue schématique en coupe d'un mode de réalisation d'un dispositif selon l'invention, dans lequel une source de type LED est associée à une source de type OLED et dans lequel l'éclairage de la source de type LED et l'éclairage de la source de type OLED sont simultanément réalisés,
- la figure 2 est une vue schématique en coupe d'un autre mode de réalisation d'un dispositif selon l'invention, dans lequel une source de type LED est associée à une source de type OLED, dans lequel l'éclairage de la source de type LED et l'éclairage de la source de type OLED sont indépendants, et dans lequel les flux lumineux sont orientés selon une première direction,
- la figure 3 est une vue schématique en coupe d'une variante du mode de réalisation de l'invention illustré par la figure 2, dans lequel l'éclairage de la source LED et l'éclairage de la source OLED sont indépendants, et dans lequel les flux lumineux sont orientés selon une deuxième direction,
- et la figure 4 est une vue schématique en coupe d'un dispositif selon l'invention, dans lequel une source de type LED est associée à une source de type OLED et dans lequel un système optique complémentaire est associé aux sources de type LED et OLED.

Il faut tout d'abord noter que si, dans ce qui suit et dans les figures, l'invention est décrite et illustrée dans un mode de réalisation dans lequel elle comporte une seule source de type LED et une seule source de type OLED, un tel mode de réalisation n'est pas exclusif et l'invention s'étend bien entendu aux modes de réalisation dans lesquels une ou plusieurs sources de type LED sont associées à une ou plusieurs sources de type OLED.

Il faut aussi noter que les figures exposent l'invention de manière détaillée pour sa mise en oeuvre, et que lesdites figures peuvent bien entendu servir à mieux définir l'invention le cas échéant. Il est également enfin à noter qu'un même élément est repéré de la même manière sur l'ensemble des figures.

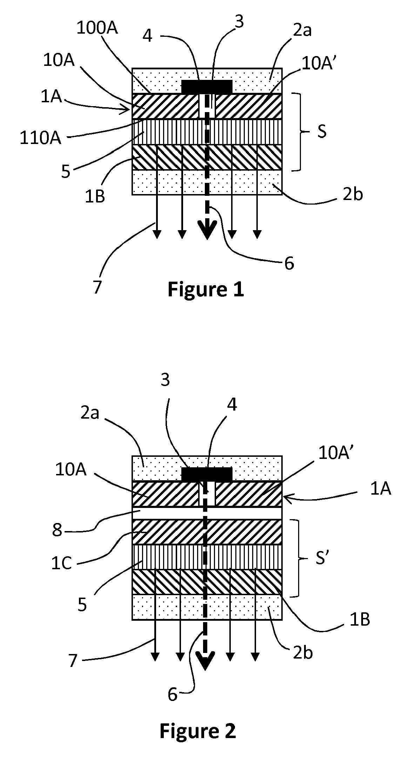

La figure 1 illustre schématiquement, en coupe, un dispositif selon l'invention mettant en oeuvre une source de type LED 4, pour diode électroluminescente ponctuelle, et une source de type OLED référencée S, pour diode électroluminescente organique. Dans ce dispositif, une première couche conductrice 1A, de faible épaisseur, 50nm par exemple, est appliquée sur une face d'un premier substrat 2a, réalisé dans un matériau translucide tel que du verre ou un matériau polymère comme, à titre d'exemple non limitatif, un PET. Avantageusement, mais non exclusivement selon le mode de réalisation illustré par la figure 1, la première couche conductrice 1A est réalisée dans un matériau conducteur translucide tel que, par exemple un matériau contenant de l'oxyde mixte d'indium et d'étain dont l'abréviation est ITO. Par des moyens appropriés, une première et une deuxième pistes conductrices 10A et 10A' sont définies dans la première couche conductrice 1A, séparées entre elles par un espace isolant 3 de faible largeur agencé au sein de ladite première couche conductrice 1A. A titre d'exemple non exhaustif, l'espace isolant 3 peut être réalisé par ablation sélective, par exemple au moyen d'un laser, d'une partie de la première couche conductrice 1A. Avantageusement, mais de manière non limitative, la largeur de l'espace isolant 3 entre les pistes conductrices 10A et 10A' est de l'ordre de quelques dixièmes de millimètre.

Une LED 4 est ensuite rapportée sur une première face 100A de la première couche conductrice 1A, par exemple par collage au moyen d'une colle conductrice, de telle manière qu'elle se trouve en contact électrique avec chacune des première et deuxième pistes conductrices 10A et 10A' qui forment alors ses pistes d'alimentation électrique. La LED 4 se trouve ainsi disposée "à cheval" sur l'espace isolant 3, entre ses deux pistes d'alimentation 10A et 10A'. Dans l'exemple illustré par la figure 1, la LED 4 est insérée dans une cavité agencée à cet effet dans le premier substrat 2a. Selon d'autres modes de réalisation avantageux non représentés, elle peut également être intégrée, à titre d'exemples non limitatifs, à une feuille thermoplastique, ou à une couche de silicone, ou à une couche de matériau de type résine époxy insérée entre la première couche conductrice 1A et le premier substrat 2a. Dans ce cas, l'épaisseur de la feuille thermoplastique, ou de la couche de silicone, ou de la couche de matériau de type résine époxy sera avantageusement choisie au moins égale à l'épaisseur de la LED 4, et le matériau qui la constitue sera avantageusement choisi pour être translucide. Selon le mode de réalisation avantageux représenté par la figure 1, mais de manière non exclusive, la LED 4 comprend sa surface éclairante et ses plots de connexion électrique qui sont sur une même face de ladite LED.

La deuxième face 110A de la première couche conductrice 1A, opposée à la première face 100A de cette même première couche conductrice 1A qui accueille la LED 4, est revêtue d'un ensemble de couches organiques 5. L'ensemble de couches organiques 5 recouvre en totalité cette deuxième face 110A de la première couche conductrice 1A, espace isolant 3 compris. Selon l'invention, l'ensemble de couches organiques 5 comprend au moins une couche émissive réalisée dans un matériau électroluminescent et un ensemble de couches de transport qui permettent, lorsqu'une tension électrique est appliquée à l'ensemble de couches organiques 5, de générer la luminescence du matériau constituant la couche émissive.

Une deuxième couche conductrice 1 B est rapportée sur l'ensemble de couches organiques 5, et est elle-même recouverte par un deuxième substrat 2b, réalisé dans un matériau translucide de faible épaisseur, par exemple du verre ou un matériau polymère tel que, à titre d'exemple non limitatif, un PET. Selon l'invention, la deuxième couche conductrice 1B est réalisée dans un matériau électriquement conducteur et optiquement translucide, par exemple un matériau contenant de l'oxyde mixte d'indium et d'étain. L'ensemble de couches organiques 5 se trouve ainsi pris en sandwich entre la première et la deuxième couches conductrices, respectivement 1A et 1 B, elles-mêmes placées entre les premier et deuxième substrats 2a et 2b.

Dans le dispositif tel qu'il vient d'être décrit et tel qu'il est illustré par la figure 1, les première et deuxième couches électriquement conductrices 1A et 1 B jouent alors le rôle d'électrodes pour une source lumineuse de type OLED S qu'elles forment avec l'ensemble de couches organiques 5 et les premier et deuxième substrats 2a et 2b. Il apparaît donc que, dans ce mode de réalisation de l'invention, la première couche conductrice 1A assure une fonction d'alimentation électrique commune à la source de type LED 4 et à la source de type OLED S : d'une part, elle joue le rôle d'électrode pour la source OLED S et, d'autre part, les pistes conductrices 10A et 10A' définies en son sein assurent l'alimentation électrique de la source de type LED 4. Dans ce mode de réalisation, la source de type LED 4 et la source de type OLED S sont donc portées à un même potentiel électrique par l'intermédiaire de la première couche conductrice 1A.

Des moyens de commande et de contrôle, non représentés sur la figure 1, permettant d'établir une tension entre, d'une part, les première et deuxième pistes conductrices d'alimentation 10A et 10A' de la LED 4, et, d'autre part, la première et la deuxième couches conductrices 1A et 1B, complètent le dispositif selon l'invention et assurent l'éclairage simultané de la LED 4 et de la source de type OLED S du dispositif.

Dans le mode de réalisation illustré par la figure 1, les tensions appliquées sont telles que le flux lumineux émis par la source de type OLED S formée des couches conductrices 1A et 1B et de l'ensemble de couches organiques 5 insérées entre les premier et deuxième substrats 2a et 2b est dirigé selon le sens représenté par les flèches en trait plein 7, le flux lumineux émis par la LED 4 étant représenté par la flèche en trait interrompu 6. Dans ce mode de réalisation, les flux lumineux émis par la source de type OLED S et par la LED 4 traversent ainsi le deuxième substrat 2b, la première couche conductrice 1A jouant le rôle de cathode pour la source de type OLED S du dispositif selon l'invention, et la deuxième couche conductrice 1 B jouant le rôle d'anode. Il apparaît clairement ici que les flux lumineux émis par les deux sources du dispositif selon l'invention se superposent, le flux lumineux émis par la source de type OLED S fournissant un éclairage de fond pour l'éclairage localisé émis par la LED 4. On conserve ainsi la possibilité de fournir un éclairage puissant et localisé, matérialisé par la surface éclairante de la LED 4, noyé dans la surface éclairante de moindre puissance de la source OLED S. Le contraste est ainsi moins fort et, donc, moins gênant pour les usagers. Il est à noter que, selon l'effet visuel recherché dans ce mode de réalisation, le substrat 2b, réalisé dans un matériau translucide, pourra également être réalisé dans un matériau transparent, transparent coloré, ou dans tout type de matériau laissant passer les rayons lumineux et permettant d'atteindre l'effet visuel recherché.

Selon une variante de réalisation, dans laquelle la première couche conductrice 1A est réalisée dans un matériau électriquement conducteur et translucide tel que, à titre d'exemple non limitatif, un matériau contenant de l'oxyde mixte d'indium et d'étain, et dans laquelle la LED choisie est du type dans lequel surface éclairante et plots de connexion électrique ne sont pas situés sur une même face de cette LED, les tensions appliquées respectivement aux première et deuxième couches conductrices 1A et 1B peuvent être telles que ce soit la première couche conductrice 1A qui joue le rôle d'anode pour la source de type OLED du dispositif selon l'invention, les flux lumineux émis par la celle-ci et par la LED du dispositif selon l'invention, superposés, étant alors orientés de manière à traverser le premier substrat 2a qui sera, dans ce cas, avantageusement choisi dans un matériau translucide permettant d'obtenir l'effet visuel recherché (matériau transparent, coloré, etc ...).

Quelle que soit l'orientation choisie pour les flux lumineux, un tel mode de réalisation de l'invention peut être, par exemple, appliqué pour réduire les risques d'éblouissement liés au fort contraste qui existe entre la zone localisée éclairée par une LED et son environnement, ou par un ensemble de LED et leur environnement. Ce mode de réalisation de l'invention peut être également appliqué pour atteindre, à partir de l'éclairage surfacique obtenu par la source de type OLED S du dispositif selon l'invention, des valeurs de puissance lumineuse et une répartition angulaire lumineuse règlementaires pour certaines fonctions d'éclairage ou de signalisation du véhicule automobile, et ce, en ayant recours à un nombre réduit de sources de type LED, et donc, en limitant les risques d'échauffement thermique liés à leur association en grand nombre.

La figure 2 illustre un mode de réalisation alternatif de l'invention dans lequel source de type LED et source de type OLED du dispositif selon l'invention peuvent être commandés totalement indépendamment l'une de l'autre.

On retrouve dans ce mode de réalisation de l'invention un premier et un deuxième substrats 2a et 2b entre lesquels sont prises en sandwich, respectivement, une première couche conductrice 1A dans laquelle sont délimitées une première et une deuxième pistes conductrices 10A et 10A' séparées par un espace isolant 3, et une deuxième couche conductrice 1 B, translucide. Une LED 4 est également ici insérée entre la première couche conductrice 1A et le premier substrat 2a, de telle manière qu'elle soit en contact électrique avec chacune des première et deuxième pistes conductrices 10A et 10A' qui constituent ainsi ses pistes d'alimentation électrique. Un ensemble de couches organiques 5, du même type que celles décrites dans le mode de réalisation illustré par la figure 1, est placé entre la première couche conductrice 1 A et la deuxième couche conductrice 1 B.

Dans le mode de réalisation illustré par la figure 2, une troisième couche conductrice 1C, réalisée dans un matériau conducteur translucide, et une couche isolante 8 réalisée dans un matériau isolant et translucide, sont insérées entre l'ensemble de couches organiques 5 et la première couche conductrice 1A. Plus précisément, la troisième couche conductrice translucide 1C est rapportée entre l'ensemble de couches organiques 5 et la première couche conductrice 1A, et la couche isolante translucide 8 est insérée entre ladite troisième couche conductrice 1C et ladite première couche conductrice 1A. Selon ce mode de réalisation, la deuxième et de la troisième couches conductrices, respectivement 1B et 1C, forment alors les électrodes d'une source de type OLED S', les pistes conductrices 10A et 10A' délimitées au sein de la première couche conductrice 1A assurant l'alimentation électrique de la LED 4. La source de type OLED S' du dispositif selon l'invention dans le mode de réalisation illustré par la figure 2 est donc formée de l'ensemble de couches organiques 5 inséré entre les deuxième et troisième couches conductrices 1B et 1C, elles-mêmes placées entre les premier et deuxième substrats 2a et 2b.

De même que précédemment, des moyens de commande et de contrôle, non représentés sur la figure 2, complètent le dispositif selon l'invention en permettant d'établir et de piloter les tensions requises pour alimenter les pistes conductrices 10A et 10A' d'alimentation électrique de la LED 4 encapsulée entre les premier et deuxième substrats 2a et 2b, d'une part, et pour le fonctionnement de la source de type OLED S', d'autre part. Les sources lumineuses LED et OLED du dispositif selon l'invention peuvent alors être commandées de manière totalement indépendante l'une de l'autre.

On voit ici l'étendue des possibilités d'application de l'invention, en particulier dans ses modes de réalisation dans lesquels plusieurs groupes de LED sont associés à un ou plusieurs groupes de sources de type OLED. En effet, l'invention permet alors, dans ce mode de mise en oeuvre, de réaliser un éclairage surfacique de puissance moyenne auquel peut se rajouter, de manière indépendante, en fonction des conditions de circulation du véhicule, un éclairage de forte puissance. A titre d'exemple non limitatif, on peut penser ici à une application à un feu arrière dans lequel la fonction "lampe de ville", également connue sous le nom de "tail", serait assurée par l'éclairage surfacique de type OLED du dispositif selon l'invention, et dans lequel la fonction "stop" serait assurée par l'éclairage d'un premier groupe de LED de ce même dispositif, une autre fonction, par exemple de type "clignotant" pouvant être assurée par un deuxième groupe de LED du même dispositif selon l'invention. L'invention permet ainsi, dans ce cas, de réaliser plusieurs fonctions différentes d'éclairage ou de signalisation du véhicule avec un seul et même dispositif, là où, actuellement, plusieurs dispositifs sont nécessaires.

Selon le mode de réalisation illustré par la figure 2, les tensions appliquées respectivement à la première couche conductrice 1A et aux deuxième et troisième couches conductrices 1B et 1C sont telles que les flux lumineux émis par la source de type LED et la source de type OLED du dispositif selon l'invention, illustrés respectivement par les flèches 6 et 7, sont orientés de manière à traverser le deuxième substrat 2b, dont le matériau sera alors avantageusement choisi pour obtenir l'effet visuel recherché : matériau translucide, matériau transparent, matériau transparent coloré, etc.

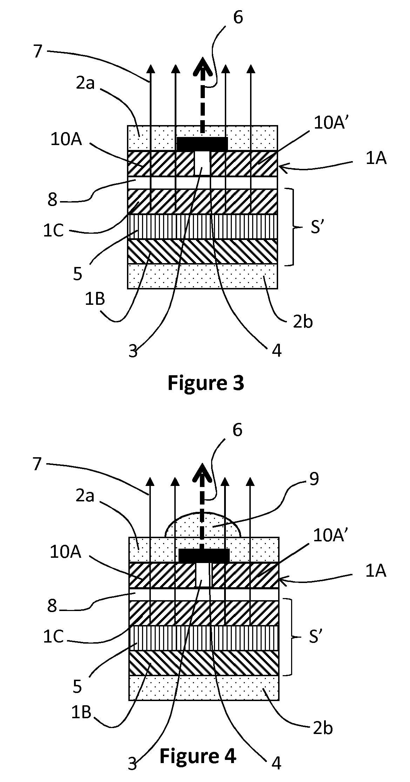

Selon un mode de réalisation alternatif de l'invention, illustré par la figure 3, dans lequel la première couche conductrice 1A est réalisée dans un matériau translucide et dans lequel la LED 4 est du type dans lequel surface éclairante et plots de connexion électrique ne sont pas situés sur une même face de cette LED, les tensions appliquées respectivement à la première couche conductrice 1A et aux deuxième et troisième couches conductrices 1B et 1C sont telles que les flux lumineux émis par la source de type OLED et la source de type LED du dispositif selon l'invention, illustrés respectivement par les flèches 6 et 7, sont orientés de manière à traverser le premier substrat 2a, dont le matériau sera, dans ce cas, avantageusement choisi pour obtenir l'effet visuel désiré.

Une autre variante de réalisation de l'invention est illustrée par la figure 4. Le mode de réalisation représenté est identique à celui représenté par la variante illustrée par la figure 3, à ceci près qu'un dispositif optique 9 est ici placé sur le premier substrat 2a à travers lequel passent les flux lumineux émis par la LED 4 et par la source de type OLED. Plus précisément, le dispositif optique 9 est formé ou apposé à la surface extérieure du premier substrat 2a, à l'opposé de la face dudit premier substrat qui accueille la première couche conductrice 1A, et il est situé au regard de la surface éclairante de la LED 4. Le dispositif optique 9 a pour rôle de concentrer les rayons lumineux qui le traversent. A titre d'exemples non exhaustifs, le dispositif optique 9 peut consister en une lentille, un collimateur, ou encore en un guide de lumière.

L'invention permet ainsi de réaliser un dispositif qui combine les avantages des dispositifs lumineux qui mettent en oeuvre des sources de type OLED, en particulier : obtention d'un éclairage surfacique, angle étendu de confort de vision, mise en oeuvre simple, temps de réponse très court, possibilité d'utilisation de substrats souples, et les avantages des dispositifs lumineux qui mettent en oeuvre des sources de type LED, en particulier : forte puissance lumineuse émise.

Elle trouve ainsi une application particulièrement intéressante au domaine de l'éclairage et/ou de la signalisation des véhicules automobiles, puisqu'elle permet, avec un seul dispositif, de remplir plusieurs fonctions qui exigent des puissances lumineuses très différentes, comme, par exemple, les fonctions réalisées par les lampes de ville et celles réalisées par les feux stop du véhicule. Par sa facilité de réalisation, l'invention est également compatible avec tout type de LED, quelle que soit la position de sa surface éclairante au regard de son circuit d'alimentation électrique.

Il est toutefois à noter que l'invention ne saurait se réduire aux moyens et configurations décrits et illustrés, mais qu'elle s'applique également à tous moyens ou configurations équivalents et à toute combinaison de tels moyens. En particulier, les variantes de réalisation illustrées par les figures 3 et 4 s'appliquent bien entendu également au mode de réalisation illustré par la figure 1.

De même, si l'invention a été décrite et illustrée ici dans des modes de réalisation dans lesquels une seule source de type LED est associée à une seule source de type OLED, il ressort clairement de ce qui précède qu'elle s'applique également au cas où plusieurs sources de type LED sont utilisées, réparties sur la surface éclairante d'une ou plusieurs sources de type OLED. Dans ce cas, selon l'invention, le ratio de surface entre sources de type LED et sources de type OLED sera avantageusement compris entre 0.02% et 2%, soit par exemple une source OLED d'une surface de 50cm² et une source LED de 1mm² formant un ratio de 1/5000, et une source OLED de 10cm² et vingt sources LED de 1mm² chacune, formant ainsi un ratio de 20/1000.

L'invention s'applique également aux cas dans lesquels, plusieurs sources de type LED étant utilisées et les LED et OLED étant commandées de manière indépendante, les moyens de commande et de contrôle de l'ensemble sont définis pour permettre un éclairage "par zones" de tout ou partie des LED réparties sur la surface éclairée par les sources de type OLED.

## Revendications

1. Dispositif d'éclairage et/ou de signalisation pour véhicule automobile, **caractérisé en ce qu'**il comprend au moins une diode électroluminescente organique (S, S') et au moins une diode électroluminescente (4) interposées entre au moins un premier et un deuxième substrats (2a, 2b) translucides.

2. Dispositif selon la revendication 1, dans lequel la diode électroluminescente (4) comprend une première surface éclairante et la diode électroluminescente organique (S, S') comprend une deuxième surface éclairante, lesdites surfaces éclairantes se chevauchant.

3. Dispositif selon la revendication 2, dans lequel la deuxième surface éclairante est plus grande que la première surface éclairante.

4. Dispositif selon la revendication 3, **caractérisé en ce que** le ratio entre la première surface éclairante et la deuxième surface éclairante est compris entre 0.02% et 2%.

5. Dispositif selon l'une quelconque des revendications précédentes, **caractérisé en ce que** l'un au moins des premier et deuxième substrats (2a, 2b) est transparent.

6. Dispositif selon l'une quelconque des revendications précédentes, **caractérisé en ce que** la diode électroluminescente (4) est du type dans lequel sa surface éclairante et ses plots de connexion sont situés sur une même face.

7. Dispositif selon l'une quelconque des revendications précédentes, **caractérisé en ce qu'**une cavité d'accueil de la diode électroluminescente (4) est agencée dans au moins l'un desdits substrats (2a, 2b).

8. Dispositif selon l'une quelconque des revendications précédentes, **caractérisé en ce qu'**il comprend au moins une première et une deuxième pistes conductrices (10A, 10A') agencées dans une première couche conductrice (1A) pour alimenter électriquement la diode électroluminescente (4), séparées entre elles par un espace (3) électriquement isolant, et **en ce que** la diode électroluminescente (4) s'étend de part et d'autre dudit espace (3), en contact électrique avec chacune des première et deuxième pistes conductrices (10A, 10A').

9. Dispositif selon l'une quelconque des revendications précédentes, **caractérisé en ce qu'**il comprend une deuxième couche conductrice (1B) d'alimentation de la diode électroluminescente organique (S, S').

10. Dispositif selon l'une quelconque des revendications précédentes, **caractérisé en ce qu'**il comprend une première couche conductrice (1A) jouant un rôle commun d'alimentation électrique pour la diode électroluminescente organique (S) et pour la diode électroluminescente (4) au travers de pistes conductrices (10A, 10A') agencées en son sein.

11. Dispositif selon l'une quelconque des revendications 2 à 9, **caractérisé en ce qu'**il comprend, d'une part, au moins une troisième couche conductrice et translucide (1C), qui alimente électriquement la diode électroluminescente organique (S') et, d'autre part, au moins une couche (8) électriquement isolante et translucide intercalée entre une première couche conductrice (1A) dans laquelle sont agencées deux pistes conductrices (10A, 10A') d'alimentation électrique de la diode électroluminescente (4) et ladite troisième couche conductrice (1 C).

12. Dispositif selon l'une quelconque des revendications précédentes, **caractérisé en ce que** l'une au moins de la première couche conductrice (1A) ou de la deuxième couche conductrice (1B) est au moins translucide à l'égard des rayons lumineux générés par la diode électroluminescente (4) et par la diode électroluminescente organique (S, S').

13. Dispositif selon l'une quelconque des revendications précédentes, **caractérisé en ce qu'**il comprend une pluralité de diodes électroluminescentes organiques (S, S').

14. Dispositif selon l'une quelconque des revendications précédentes, **caractérisé en ce qu'**au moins un desdits premier ou deuxième substrats (2a, 2b) comprend un dispositif optique (9) de concentration des rayons lumineux.

15. Dispositif selon la revendication 14, **caractérisé en ce que** ledit dispositif optique (9) est formé sur une surface extérieure dudit substrat (2a, 2b), et disposé au moins au regard de la surface éclairante d'au moins une diode électroluminescente (4).

16. Feu arrière de véhicule automobile, **caractérisé en ce qu'**il comprend au moins un dispositif d'éclairage et/ou de signalisation selon l'une quelconque des revendications 1 à 15.
